Europäisches Patentamt

European Patent Office

Office européen des brevets

(11) Publication number: **0 196 346
B1**

(12) **EUROPEAN PATENT SPECIFICATION**

(45) Date of publication of patent specification: **19.07.89**

(21) Application number: **85103926.3**

(22) Date of filing: **02.04.85**

(51) Int. Cl.⁴: **B 23 K 26/06,** H 01 S 3/00,
H 01 L 21/268 // C23F1/02,
C23C16/04

(54) Apparatus for manufacturing surface structures in the nanometer range.

(43) Date of publication of application:
**08.10.86 Bulletin 86/41**

(45) Publication of the grant of the patent:
**19.07.89 Bulletin 89/29**

(84) Designated Contracting States:
**DE FR GB**

(56) References cited:
**EP-A-0 057 587
EP-A-0 068 077
EP-A-0 112 401
EP-A-0 112 402
US-A-4 314 623**

(73) Proprietor: **International Business Machines
Corporation
Old Orchard Road
Armonk, N.Y. 10504 (US)**

(72) Inventor: **Gimzewski, James Kazimierz, Dr.
Milchbuckstrasse 1
CH-8057 Zürich (CH)**
Inventor: **Pohl, Wolfgang Dieter, Dr.
Felsenhofstrasse 10
CH-8134 Adliswil (CH)**
Inventor: **Duerig, Urs Theodor, Dr.
Sunnehus im Bad
CH-8128 Hinteregg (CH)**

(74) Representative: **Rudack, Günter O., Dipl.-Ing.
IBM Corporation Säumerstrasse 4
CH-8803 Rüschlikon (CH)**

Courier Press, Leamington Spa, England.

## Description

This invention relates to an apparatus for manufacturing surface structures in the nanometer range by means of a laser beam directed onto a target surface.

Microfabrication processes using laser beams as an excitation source to overcome the activation energy of thermodynamically allowed but kinetically hindered surface reactions, are of technological interest in the fabrication of electronic circuits and memory devices. Present-day manufacturing techniques permit the fabrication of surface structures down to some tenths of a micrometer but not beyond, because of the impossibility of focusing light beams to a spot size below one half of the wavelength of the radiation of those beams. While most of the techniques now employed in the manufacture of submicron structures use subtractive methods, like etching, to get down to the desired dimensions, one would like to also dispose of additive techniques which permit the deposition of metals, such as iron, cadmium, lead, aluminium, and of dopants, like silicon, germanium, boron, nitrogen, phosphorus, etc., with a lateral-spatial resolution in the submicron range.

It is an object of the present invention to propose apparatus that is capable of depositing materials onto the surface of some substrate and/ or of etching the structures on such surface, both down to a resolution in the nanometer range. To this end, the invention relies on two phenomena which are per se known but which, taken alone, do not lead to the desired result. Their combination has, however, not yet been attempted. These phenomena are the photo-dissociation of metal-containing gases or vapours by means of a laser beam, and the creation of a narrow optical near-field by means of a subwavelength aperture. This combination permits the manufacture of surface structures, in particular the manufacture of electronic circuitry, in the 30 nanometer range with comparatively little expenditure. Also, with such a narrowly focused laser beam, surface structures on semiconductors, like silicon, gallium arsenide, etc., may be etched with the same lateral-spatial resolution.

Photo-dissociation and etching by means of a laser beam are known, for example, from D. J. Ehrlich and J. Y. Tsao, Review of Laser-Micromechanical Processing, J.Vac. Sci.Technol. B1(4) 1983, p. 969-984. The primary physical situation involves an ultra-violet or visible-light laser beam focused to an about one micrometer spot on a substrate in contact with either a liquid, or a species adsorbed on the surface from the gas phase, or a moderate-pressure molecular vapour. This leads to direct photo-dissociation, and, — in the case of organometallic compounds, yields supersaturated metal vapours through the absorption of short-wavelength laser photons by the molecules of the organometallic gas or vapour. For such complex molecules like metal carbonyls and metal halides and more tightly bound metal alkyls, free metal atoms are only generated after several sequential single-photon absorption events in which the molecule is progressively broken down. The free metal atom will then settle down on the surface, or absorbed molecules will decompose in the illuminated area, essentially at the focal point of the laser beam. A survey of laser-aided manufacturing processes is contained in R. M. Osgood and T. F. Deutsch, "Laser-Induced Chemistry for Microelectronics", Science Vol. 277 (1985) No. 4688, pp. 709-714. The reduction of line widths can be achieved through still more narrow focusing of the laser beam. Line widths may be determined by surface diffusion and kinetics. Detailed control of these properties can be achieved through suitable selection of the target temperature.

For etching, electronic and vibrational excitation can lead to local dissociation and desorption. Alternatively, reactivity of the material at the surface enhanced by the heat of the impinging laser beam, particularly if the surface temperature is locally raised to the melting point of the surface material. In both areas further improvements should be possible through reduction of the beam diameter.

The diffraction limit of $\lambda/2...3$ is the lower bound in resolution to any optical image formation. It determines the diameter to which a beam of radiation can be focused. Yet there are ways to circumvent the diffraction limit. One such way was disclosed by D. W. Pohl, W. Denk and M. Lanz, Optical Stethoscopy:Image Recording with Resolution $\lambda/20$, Appl.Phys.Lett. 44(7) 1984, pp. 651-653. Reference is also made to EP-A1-0112401 and EP-A1-0112402.

The resolution-limiting lens is replaced by a sharply pointed, optically transparent body, such as a quartz crystal, covered with an opaque metal layer and polished optically flat at the end opposite of the point. At the apex of the point, the metal layer is mechanically destroyed leaving an aperture of about 10-20 nm diameter. If the laser beam is entered at the aperture-far end of the crystal, a spot diameter in the 20 nm range can be obtained.

The invention contemplates the combination of the two phenomena mentioned before to propose apparatus for manufacturing surface structures in the nanometer range by means of a laser beam directed onto the surface of a target arranged inside a processing chamber which is evacuatable to ultra high vacuum, and which has tubing and gauge means for introducing reactant gases into said processing chamber and for maintaining a predetermined partial pressure of such reactant gases inside said processing chamber, the apparatus being characterized by a laser light source associated with an aperture having a diameter of about $\lambda/20$, where $\lambda$ is the laser wavelength, a support for said target, and means permitting mutual displacement between laser beam and target, the aperture and the target being commonly mounted on said support which is vibration-insulated from the outside world by means of a damping system, the distance between the aperture and the target being between 1 and 10 nanometers.

Details of two embodiments of the invention are hereafter described, by way of example, with reference to the attached drawings in which:

Fig. 1 is a schematic diagram of the apparatus in accordance with the invention;

Fig. 2 is a schematic diagram of a different embodiment of the invention.

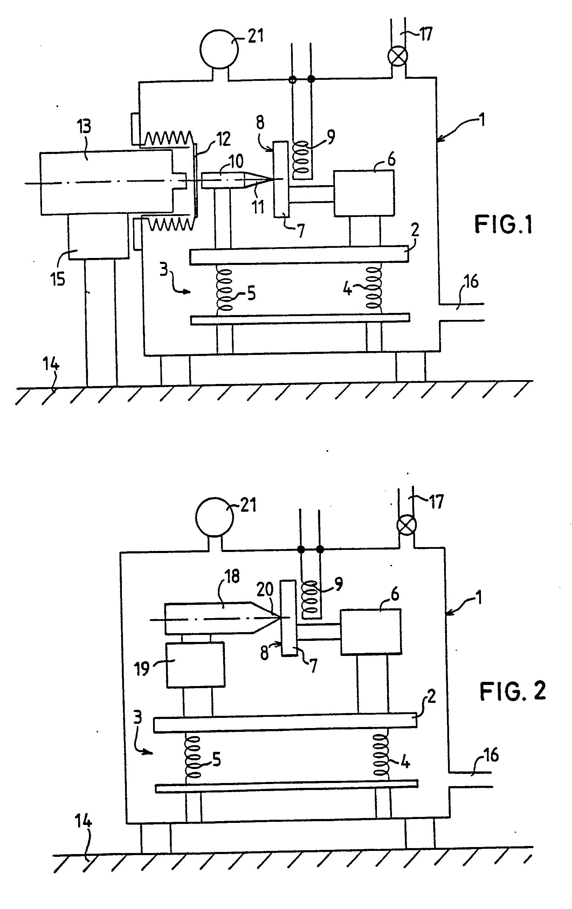

Referring to Fig. 1, there is shown a processing chamber 1 in which a base 2 is arranged on top of a vibration damping system 3, for example one of the type comprising a set of springs 4, 5, which insulates the manufacturing apparatus of the invention from the outside world. The damping system should be most effective at low frequencies. Of course, any other effective vibration attenuation system may be employed.

Base 2 supports a xyz-drive module 6 which in turn carries the target 7, i.e. the device, structure, etc., the surface 8 of which is to be treated. The temperature of target 7 may be raised or lowered, as the intended treatment may require, by a heating/cooling system 9.

Also supported on base 2 is an optical waveguide 10 consisting of an optically transparent body, e.g. a quartz crystal, having a sharply pointed tip 11 directed against target 7. Tip 11 has a diameter of a few tens of nanometers at its apex. It is covered with an opaque metal layer into which an aperture of about 10 nm diameter was machined (for example, using the method disclosed in EP-A1-0112402). The aperture-far end of waveguide 10 is polished optically flat and directed against a quartz window 12 in processing chamber 1. Quartz window 12 is adjustable so as to permit a short distance between waveguide 10 and an external laser source 13 which is supported on a bench 14 on which processing chamber 1 rests, too. Laser source 13 may be aligned with the aperture at tip 11 of waveguide by means of an xyz-drive module 15.

Processing chamber 1 may be connected to a vacuum system by means of tubing 16 and to a reagent gas supply by means of tubing 17. This permits evacuation of the chamber and maintenance of a controlled atmosphere of an organometallic vapour for material deposition processes.

Organometallic vapours of interest in the deposition of fine lines are metal alkyls and metal carbonyls such as, for example, $Cd_3(CH_2)$, $Ga(CH_3)_3)$ and $W(CO)_6$. Typical wavelengths for the laser excitation are in the range of 257 nm, the path length of the laser beam within the gas atmosphere being adjusted to several millimeters. The power requirements for the laser are in the range of milliwatt. Through absorption of energy, the adsorbed gas molecules are decomposed to the reduced phase (e.g. Cd, Ga, W) by a localized photochemical reaction. Free metal atoms are then bonded to the surface 8 of target 7.

The spatial resolution of the chemical reaction and, hence, of the deposition of material is determined by the size of the optical near-field at the aperture 11. The aperture behaves like a radiating dipole to first approximation. It is known from the theory of electromagnetism that the electric energy density of a dipole decays with the sixth power in its near-field. Thus, only immediate neighbourhood of the aperture gets exposed to electromagnetic energy of a brightness sufficient for a photochemical reaction. Target surface 8, therefore, has to be placed at a distance from the aperture which is smaller than its diameter, for instance < 5 nm. Any surface roughness causing variations of said distance as target 7 is displaced with respect to stationary tip 11 leads to appropriate adjustments in xyz drive module 6 through a feedback loop, using in-situ capacitance monitoring well known in the art, or more preferably, tunnel current controlled distance stabilization. The latter works as follows. Tip 11 of waveguide 10 carries a metallization on its surface for optical reasons, and with a potential applied between said metallization and target 7, a tunnel current will flow when the distance tip/surface is about 1 nm. When there is a mutual displacement between tip 11 and target 7, say along a distance only of several micrometers, the surface roughness to be expected even for highly lapped surfaces will at least be of the order of that distance. The tunnel current will vary accordingly, and it is this variation that is coupled back to the z-control section of the fine-positioning xyz-drive module, e.g. module 6 in Fig. 1. Experiments with the Scanning Tunneling Microscope of US-A-4,343,993 have shown that variations of the tip/target distance of the order of 0,01 nm can be compensated.

The velocity with which the laser micromechanical reaction proceeds depends in a complex way on size and brightness of the light source as well as on gas pressure, chemical kinetics, temperature and surface properties of the target. For line widths around 1 µm, the deposition rate can be expected to be 1...5 µm/s, while the etching rate is between 0,01 and 0,1 µm/s. the process speed in terms of deposition/etching in thickness per unit time for narrow structures is orders of magnitude higher than for large-area processing.

Fig. 2 shows a modified embodiment of the apparatus of the present invention. While in Fig. 1 the laser apparatus is localized outside of processing chamber 1, the embodiment of Fig. 2 employs a semiconductor laser forming an integral part of the waveguide and tip. A semiconductor laser with integrated pyramidal tip is known from EP-A1-0112402. Briefly, the lasing zone of the semiconductor laser is sandwiched in between two waveguiding layers which are laterally enclosed, in turn, by bulk semiconductor material. Opposite the lasing zone there is a metal layer which is connected to the outside world for energy supply. The entire structure is coated with an insulating layer and a final opaque layer. One end of the laser is shaped in the form of a sharply pointed pyramid. At its apex, an aperture is provided for exposing the lasing zone, the aperture having a diameter of less than 30 nm. The aperture is directed on surface 8 of target 7.

Semiconductor laser 18 is movably supported on a xyz-drive module 19 sitting on base 2. In this embodiment, both xyz-drive modules 6 and 19 may be designed alternatively to permit coarse or fine displacement between the tip 20 and target 7, and there is no preference.

In operation, after target 7 has been properly placed on xyz-drive module 6, processing chamber 1 is evacuated through tubing 16, and the desired gas atmosphere is obtained through tubing 17 with the aid of a pressure gauge 21. Target 7 is then brought up or down to the appropriate process temperature, as the case may be. Now the operating distance and alignment of laser 13 and waveguide 10, or semiconductor laser 18, respectively, are chosen by appropriately actuating xyz-drive modules 15 and 19.

With a potential applied between the metallization on the surface of tip 11 (or tip 20) and the target 7, a tunnel current will flow when the distance between tip and target is of the order of one nanometer. That current will be between $10^{-7}$ A and $10^{-10}$ A. Once the tunnel current has started flowing, its intensity is maintained essentially constant by monitoring the variations and feeding them back to the z-input of xyz-drive module 6 for re-adjustment of the distance between tip 11 (20) and target 7.

The continuous monitoring of the tunnel current, i.e. of the tip/target distance is of particular importance as the tip is scanned across the surface of target 7 in a raster fashion. This scanning action is obtained by appropriately actuating the x- and y-inputs of xyz-drive module 6. Those skilled in the art of raster scanning will appreciate that this can best be achieved by microprocessor control.

The xyz-drive modules used in the implementation of the present invention are well known in the art and commercially available. Well suited for the intended purposes are those modules that consist of piezoelectric elements and which are capable of performing steps in the nanometer range at relatively low voltages. With the piezoelectric xy positioner of EP-A2-0149017 (Appln.Nr. 84112186.6), for example, displacements of the order of 0,5 μm/V are easily performed.

As the tip 11, 20 is scanned across the surface of target 7, it accesses each matrix point thereof for so long as is necessary for the servo mechanism to re-adjust the tip/target distance and for the photochemical reaction to take place in the desired amount. In other words, the tip is controlled to follow the contour of surface 8 of target 7. As a result of this, the ambient conditions at the tip 11/20 are always the same: Constant distance results in an almost constant number of gas molecules between tip 11, 20 and surface 8, and a constant interaction between those gas molecules and the laser beam. Variation of the ambient conditions is easily achieved by varying the partial pressure of the organometallic gas or vapour as well as by altering the surface coverage of adsorbed reactant via the temperature of target 7. Furthermore, temperature differentials between target and sample could be advantageous for deposition processing.

Of course, the operation of the apparatus in accordance with the present invention may be entirely automated using a personal computer, for example, to control the appropriate selection and partial pressure of gases, to re-adjust the tip/target distance, target and tip temperature, and to govern the entire scanning procedure.

In contrast to classical thermally activated surface chemical reactions, photon-surface and photon-surface-gas interactions may be locally activated. The lifetimes of the excited intermediates, surface diffusion properties, and other kinetic considerations can play a determining role in respect of the linewidths acheived. For certain reaction conditions, the laser beam "diameter" may not always be the primary factor for the linewidth. In the case of surface diffusional limitations, independent control of the target temperature (i.e. lower temperatures) will reduce the diffusion while essentially leaving the activation of the reaction rate determined by photon-induced processes. The independent control of surface diffusion by temperature, of reactant coverage through reactant absorption characteristics (pressure and temperature) of the reaction rate via photon energy and flux, and of the apparent photon beam size by optical near-field methods, are essential for photon-induced nanometer-scale surface structure fabrication. Here, the apparatus described above will play an important role.

## Claims

1. Apparatus for manufacturing surface structures in the nanometer range by means of a laser beam directed onto the surface (8) of a target (7) arranged inside a processing chamber (1) which is evacuatable to ultra high vacuum, and which has tubing (16, 17) and gauge means (21) for introducing reactant gases into said processing chamber (1) and for maintaining a predetermined partial pressure of such reactant gases inside said processing chamber (1), characterized by a laser light source (13, 18) associated with an aperture (11, 20) having a diameter of about λ/20, where λ is the laser wavelength, a support (2) for said target (7), and means (6, 15, 19) permitting mutual displacement between laser beam and target (7), the aperture (11, 20) and the target (7) being commonly mounted on said support (2) which is vibration-insulated from the outside world by means of a damping system (3), the distance between the aperture (11, 20) and the target (7) being between 1 and 10 nanometers.

2. Apparatus in accordance with claim 1, characterized in that the laser light source (13) is installed on the outside of said processing chamber (1), facing a quartz window (12) therein and aligned with said aperture (11), and that the aperture (11) and a xyz-drive module (6) carrying the target (7) are mounted on a common base (2).

3. Apparatus in accordance with claim 1, characterized in that the laser light source comprises a semiconductor laser (18) having a sharply pointed tip (20) at the exit side thereof, forming an aperture of a diameter of less than 30nm, said semiconductor laser (18) being installed inside said processing chamber (1) on a common base (2) together with said target (7).

4. Apparatus in accordance with claim 1, characterized in that the common base (2) is supported on a damping system (3) consisting of a set of springs (4, 5) and being designed for maximum vibration attenuation at low frequencies.

5. Apparatus in accordance with claim 1, characterized in that a heating/cooling device (9) is provided for adjusting the operating temperature of the target (7).

6. Apparatus in accordance with claim 1, characterized in that the distance between the tip (11, 20) and the target (7) is such that a tunnel current can flow across the gap between the tip (11, 20) and the surface (8) of the target (7), and that means (6) are provided for using any variation of the tunnel current to automatically re-adjust said distance so as to re-establish the initial value of the tunnel current.

## Patentansprüche

1. Vorrichtung zum Herstellen von Oberflächenstrukturen im Nanometerbereich mittels eines auf die Oberfläche (8) eines innerhalb einer bis zum Ultrahochvakuum evakuierbaren Prozeßkammer (1) angeordneten Objekts (7) gerichteten Laserstrahls, wobei die Prozeßkammer (1) Zu- und Ableitungen (16, 17) sowie Ventile (21) für das Einleiten von reaktiven Gasen und zum Aufrechterhalten eines vorbestimmten Partialdrucks dieser reaktiven Gase in der Prozeßkammer (1) aufweist, gekennzeichnet durch eine Laserlichtquelle (13, 18), die mit einer einen Durchmesser von angenähert λ/20 aufweisenden Apertur (11, 20) verbunden ist, worin λ die Laserwellenlänge bedeutet, durch einen Träger (2) für das genannte Objekt (7), und durch Mittel (6, 15, 19) für das gegenseitige Verschieben von Laserstrahl und Objekt (7), wobei die Apertur (11, 20) und das Objekt (7) gemeinsam auf dem Träger (2) montiert sind, der mittels eines Dämpfungssystems (3) von der Außenwelt vibrationsisoliert ist, und wobei der Abstand zwischen der Apertur (11, 20) und dem Objekt (7) zwischen 1 und 10 Nanometer beträgt.

2. Vorrichtung nach Anspruch 1, dadurch gekennzeichnet, daß die Laserlichtquelle (13) außerhalb der Prozeßkammer (1) angeordnet und auf ein Quarzfenster (12) derselben ausgerichtet ist, und daß die Apertur (11) und ein xyz-Antriebsmodul (6), der das Objekt trägt, auf einer gemeinsamen Basis (2) angeordnet sind.

3. Vorrichtung nach Anspruch 1, dadurch gekennzeichnet, daß die Laserlichtquelle (13) einen Halbleiterlaser (18) umfaßt, der an seiner Ausgangsseite eine scharfe Spitze (20) aufweist, die eine Apertur mit einem Durchmesser von weniger als 30 nm bildet, wobei der Halbleiterlaser (18) zusammen mit dem Objekt auf einer gemeinsamen Basis (2) innerhalb der Prozeßkammer (1) angeordnet ist.

4. Vorrichtung nach Anspruch 1, dadurch gekennzeichnet, daß die gemeinsame Basis (2) auf einem Dämpfungssystem (3) angeordnet ist, das einen Satz Federn (4, 5) umfaßt und für maximale Dämpfung bei niedrigen Frequenzen ausgelegt ist.

5. Vorrichtung nach Anspruch 1, dadurch gekennzeichnet, daß die Temperaturregelung des Objekts (7) ein Heiz- bzw. Kühlaggregat (9) vorgesehen ist.

6. Vorrichtung nach Anspruch 1, dadurch gekennzeichnet, daß der Abstand zwischen der Spitze (11, 20) und dem Objekt (7) so groß ist, daß über den Spalt zwischen der Spitze (11, 20) und der Oberfläche (8) des Objekts (7) ein Tunnelstrom fließen kann, und daß Mittel (6) vorgesehen sind, die jede Änderung des Tunnelstroms ausnutzen, um den genannten Abstand nachzuregeln, um die ursprüngliche Größe des Tunnelstroms wiederherzustellen.

## Revendications

1. Appareil destiné à fabriquer des structures superficielles dans la gamme du nanomètre au moyen d'un faisceau laser dirigé sur la surface (8) d'une cible (7) disposée à l'intérieur d'une chambre (1) de traitement qui est susceptible d'être mise sous vide à un niveau extrêmement poussé, et qui possède des tuyauteries (16, 17) et des moyens de mesure (21) destinés à introduire des gaz réactifs dans ladite chambre (1) de traitement et à maintenir à une pression partielle prédéterminée de tels gaz réactifs à l'intérieur de ladite chambre (1) de traitement, caractérisé par une source de lumière laser (13, 18) associée à une ouverture (11, 20) ayant un diamètre d'environ λ/20, λ étant la longueur d'onde du laser, un support (2) destiné à ladite cible (7), et des moyens (6, 15, 19) permettant un déplacement mutuel entre le faisceau laser et la cible (7), l'ouverture (11, 20) et la cible (7) étant montées en commun sur ledit support (2), qui est isolé des vibrations provenant du monde extérieur au moyen d'un dispositif (3) d'amortissement, la distance entre l'ouverture (11, 20) et la cible (7) étant comprise entre 1 et 10 nanomètres.

2. Appareil selon la revendication 1, caractérisé en ce que la source de lumière laser (13) est installée à l'extérieur de ladite chambre (1) de traitement, en face d'une fenêtre (12) de quartz qui s'y trouve et qui est alignée avec ladite ouverture (11), et en ce que l'ouverture (11) et un module (6) d'entraînement xyz qui porte la cible (7) sont montés sur une base commune (2).

3. Appareil selon la revendication 1, caractérisé en ce que la source de lumière laser comporte un laser (18) à semi-conducteurs possédant un bout (20) à pointe fine situé du côté de la sortie de celui-ci, constituant une ouverture d'un diamètre inférieur à 30 nm, ledit laser (18) à semi-conducteurs étant installé à l'intérieur de ladite chambre (1) de traitement avec ladite cible (7) sur une base commune (2).

4. Appareil selon la revendication 1, caractérisé en ce que la base commune (2) est supportée par un dispositif (3) d'amortissement qui consiste en un jeu de ressorts (4, 5) et qui est conçu pour exercer une atténuation maximale des vibrations à basses fréquences.

5. Appareil selon la revendication 1, caractérisé en ce qu'un dispositif (9) de chauffage/refroidissement est prévu pour régler la température de fonctionnement de la cible (7).

6. Appareil selon la revendication 1, caractérisé en ce que la distance entre le bout (11, 20) et la cible (7) est telle qu'un courant de tunnel peut passer à travers l'interstice situé entre le bout (11, 20) et la surface (8) de la cible (7), et que des moyens (6) sont prévus pour utiliser toute variation du courant de tunnel de manière à réajuster automatiquement ladite distance de façon à rétablir la valeur initiale du courant de tunnel.

FIG.1

FIG. 2